# EUROPEAN PATENT SPECIFICATION

(11) **EP 2 190 887 B1**
(45) Date of publication and mention of the grant of the patent: **04.05.2011**
(21) Application number: 08803696.7
(22) Date of filing: 05.09.2008
(51) Int. Cl.: C08F 2/50

(54) **PHOTOINITIATORS FOR ENERGY CURING**
FOTOINITIATOREN FÜR ENERGIEHÄRTUNG
PHOTO-INITIATEURS POUR DURCISSEMENT PAR UNE ÉNERGIE

(30) Priority: 17.09.2007 IT VA20070073
(43) Date of publication of application: 02.06.2010
(73) Proprietor: Lamberti Spa, 21041 Albizzate (VA) (IT)
(72) Inventor: ROMAGNANO, Stefano, I-20020 Lainate (MI) (IT); NORCINI, Gabriele, I-21020 Comabbio (VA) (IT); LI BASSI, Giuseppe, I-21026 Gavirate (VA) (IT); VISCONTI, Marco, I-21100 Varese (IT); DIETLIN, Celine, F-68093 Mulhouse Cedex (FR); ALLONAS, Xavier, F-68093 Mulhouse Cedex (FR); FOUASSIER, Jean Pierre, F-68093 Mulhouse Cedex (FR)
(86) International application number: PCT/EP2008/061726
(87) International publication number: WO 2009/037130

(56) References cited:
- EP-A- 1 617 288
- JP-A- 2006 316 177

## Description

This invention concerns photopolymerisable systems containing compounds that, by photochemical decomposition, generate fragments capable of inducing the radical photopolymerization of oligomers and/or monomers having ethylenically unsaturated groups; the photopolymerizable systems are useful for the UV curing of coatings and photolithographic formulations.

Photoelimination reactions and homolytic cleavage of ketones have been thoroughly investigated by organic chemists since the beginning of the last century. Nonetheless, relatively few compounds containing a carbonyl group but different from alpha substituted aromatic ketones, beside generating radical fragments, are able to initiate photopolymerization of ethylenically unsaturated compounds and are suitable as photoinitiators in coating UV curing formulations. Among these compounds we cite for example camphorquinone, metallocenes, aromatic phenylglyoxalic acid esters and acylphosphine oxides, which are well known photoinitiators for radiation curable resins.

As far as the applicant knows, the use of compounds of formula (I) 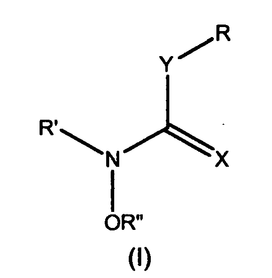 as photoinitiator of UV photopolymerisable systems for coatings or photolithography is not disclosed by the prior art.

In formula (I)
X and Y are independently of each other O or S;
R is phenyl or phenyl which is substituted by one ore more of the radicals C₁-C₁₂ linear or branched alkyl or C₅-C₈ cycloalkyl, C₁-C₄-haloalkyl, halogen, nitro, cyano, phenyl, benzyl, OR₀, NR₁R₂, SR₃, benzoyl, S(=O)-phenyl, S(=O)₂-phenyl and/or-S-phenyl, the substituents OR₀, NR₁R₂, SR₃, possibly forming 5- or 6-membered rings, via the radicals R₀,R₁,R₂, and/or R₃, or with further substituents on the phenyl ring or with one of the carbon atoms of the phenyl ring, or R is 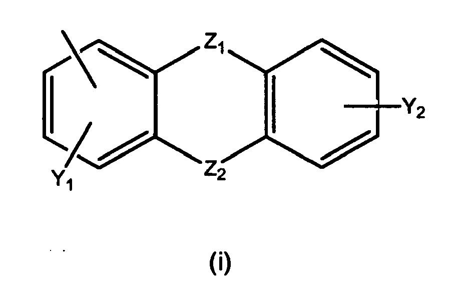 where Z₁ and Z₂, are independently of each other single bond, S, O, S=O, S(=O)₂, C=O, C=S, NR₁, C(=N)R₁, C₁-C₂ alkylene which may be unsubstituted or substituted by a C₁-C₁₂ alkyl, and Y₁ and Y₂, are independently of each other C₁-C₁₂ linear o branched alkyl, C₁-C₄-haloalkyl, cycloalkyl, halogen, phenyl, benzyl, OR₀, NR₁R₂, SR₃, benzoyl, S(=O)-phenyl, S(=O)₂-phenyl and/or-S-phenyl, the substituents OR₀, NR₁R₂, SR₃ possibly forming 5- or 6-membered rings via the radicals R₀,R₁,R₂ and/or R₃, with further substituents on the phenyl ring or with one of the carbon atoms of the aromatic ring, or R is naphthyl, anthracyl, phenanthryl, the radicals naphthyl, anthracyl and phenanthryl being unsubstituted or substituted by one or more linear or branched C₁-C₆ alkyl or or C₅-C₈ cycloalkyl, phenyl, OR₀, NR₁R₂, SR₃ and/or S-phenyl_{;} the substituents OR₀, NR₁R₂, SR₃ possibly forming 5- or 6-membered rings, via the radicals R₀, R₁, R₂ and/or R₃, with further substituents on the naphthyl, anthracyl or phenanthryl ring or with one of the carbon atoms of the naphthyl, anthracyl or phenanthryl ring,
or R is a 5- or 6-membered heterocyclic unstaurated radical comprising one or two heteroatoms selected from O, S and N, which is unsubstituted or substituted by C₁-C₆ alkyl, phenyl, OR₀, NR₁R₂, SR₃ and/or S-phenyl, the substituents OR₀, NR₁R₂, SR₃ possibly forming 5-or fi-membered rings via the radicals Ro, R₁, R₂ and/or R₃ or with further substituents on the heterocyclic unstaurated radical or with one of the carbon atoms of the heterocyclic unstaurated radical;
R' is a C₁-C₁₂ linear or branched alkyl group or C₅-C₈ cycloalkyl, unsubstituted or substituted by OH, C₁-C₄ alkoxy, SH, NR₁R₂, phenyl, benzyl, benzoyl, C₁-C₁₂ alkylsulfonyl, phenylsulfonyl, (4-methylphenyl)sulfonyl and/or C₁-C₆ alkanoyl, or C₅-C₈ cycloalkyl, or R' is C₂-C₁₂ alkyl interrupted by one or more -O-, said interrupted C₂-C₁₂ alkyl being unsubstituted or substituted by OH, C₁-C₄alkoxy, C₁-C₁₂ alkylsulfonyl, phenylsulfonyl, (4-methylphenyl)sulfonyl and/or C₁-C₆alkanoyl,
or R' is phenyl, or phenyl which is substituted by one ore more of the radicals C₁-C₁₂ alkyl or C₅-C₈ cycloalkyl, C₁-C₄-haloalkyl, halogen, phenyl, OR₀, NR₁R₂, SR₃, benzoyl, S(=O)-phenyl, S(=O)₂-phenyl and/or-S-phenyl, the substituents OR₀, NR₁R₂, SR₃ possibly forming 5- or 6-membered rings via the radicals R₀,R₁,R₂ and/or R₃ or with further substituents on the phenyl ring or with one of the carbon atoms of the phenyl ring;
R" has one of the meaning of R',
or R" is (C=O)R"', and R'" has one of the meaning of R';
R₀ is hydrogen, phenyl, benzyl, C₁-C₁₂ alkyl or or C₅-C₈ cycloalkyl which are unsubstituted or substituted by phenyl, benzyl, benzoyl, OH, C₁-C₁₂ alkoxy, C₁-C₁₂ alkylsulfonyl, phenylsulfonyl, (4-methylphenyl)sulfonyl and/or by C₂-C₈-alkanoyl, or Ro is C₂-C₁₂ alkyl interrupted by one or more -O-, said interrupted C₂-C₁₂alkyl being unsubstituted or substituted by phenyl, OH, C₁-C₄ alkoxy, C₁-C₁₂ alkylsulfonyl, phenylsulfonyl, (4-methylphenyl)sulfonyl and/or by C₂-C₆ alkanoyl;
R₁ and R₂ independently of one another are hydrogen, C₁-C₁₂ alkyl which is unsubstituted or substituted by OH, C₁-C₄ alkoxy, C₁-C₁₂ alkylsulfonyl, phenylsulfonyl, (4-methylphenyl)sulfonyl and/or C₁-C₆alkanoyl;
or R₁ and R₂ are C₂-C₁₂ alkyl interrupted by one or more -O-, said interrupted C₂-C₁₂ alkyl being unsubstituted or substituted by OH, C₁-C₄ alkoxy, C₁-C₁₂alkylsulfonyl, phenylsulfonyl, (4-methylphenyl)sulfonyl and/or C₁-G₆ alkanoyl,
or R₁ and R₂ are phenyl, C₂-C₆ alkanoyl, benzoyl, C₁-C₆ alkylsulfonyl, phenylsulfonyl, (4-methylphenyl)sulfonyl, naphthylsulfonyl, anthracylsulfonyl or phenanthrylsulfonyl,
or R₁ and R₂, together with the nitrogen atom to which they are bonded, form a 5-, 6- or 7-membered ring which may be interrupted by -O-, -S- or by -NR₀-;
R₃ is C₁-C₁₂ alkyl which is unsubstituted or substituted by OH and/or C₁-C₄alkoxy
or R₃ is C₂-C₁₂ alkyl interrupted by one or more -O-, said interrupted C₂-C₁₂ alkyl is unsubstituted or substituted by OH and/or C₁-C₄alkoxy.

EP 1 617 288 reports the use of N-oxyamide compounds, together with a photoinitiator in photosensitive compositions for lithographic printing plates; the N-oxyamide compounds are said to enhance the photosensitivity of the system, the interaction with the photoinitiator, the sensitivity and stability in ageing.

Nonetheless EP 1 617 288 does not teach the use of N-oxyamide compounds as the sole photoinitiators in the photosensitive composition.

It has now been found that the compounds of formula (I) act as photoinitiators by themselves, i.e. they generate by photochemical decomposition fragments which are capable of inducing the polymerization of radically photopolymerisable ethylenically unsaturated monomers and oligomers and that the obtained polymerization rates make them suitable for use in coatings and photolithography.

Photopolymerisable systems comprising radically photopolimerisable oligomers and/or monomers having ethylenically unsaturated groups and, as photoinitiator, at least one compound of formula I are a fundamental object of the present invention, and are particularly useful for the preparation of clear coatings, inks and lithographic systems.

The preferred compounds of formula I are those in which
R is naphthyl, the naphthyl radical being unsubstituted or substituted by one or more linear or branched C₁-C₆ alkyl or or C₅-C₈ cycloalkyl, phenyl, OR₀, NR₁R₂, SR₃ and/or S-phenyl, the substituents OR₀, NR₁R₂, SR₃ possibly forming 5- or 6-membered rings via the radicals R₀, R₁, R₂ and/or R₃, with further substituents on the naphthyl ring or with one of the carbon atoms of
the naphthyl ring,
or R is phenyl or phenyl which is substituted by one or more radicals C₁-C₁₂ linear or branched alkyl or C₅-C₈ cycloalkyl, C₁-C₄-haloalkyl, halogen, nitro, cyano, phenyl, benzyl, OR₀, NR₁R₂, SR₃, benzoyl, S(=O)-phenyl, S(=O)₂-phenyl and/or-S-phenyl, the substituents OR₀, NR₁R₂, SR₃, possibly forming 5- or 6-membered rings, via the radicals R₀,R₁,R₂, and/or R₃, with further substituents on the phenyl ring or with one of the carbon atoms of the phenyl ring;
R' is a C₁-C₆ linear or branched alkyl group or C₅-C₈ cycloalkyl,
and R" is (C=O)R"', and R"' has one of the above reported meanings.

More preferably, the compounds of formula (I) are those wherein R is phenyl, or naphthyl and R' is methyl. These compounds in which X and Y are S, and R" is (C=O)R"' with R"' isopropyl or cyclohexyl are a further object of the present invention and are particularly preferred for the realisation of the present invention because they impart high polymerization rates and conversions to the photopolymerizable system when they are use as the sole photoinitiators It has also been found that the compounds of formula I wherein R has any one of the meaning detailed above but is different from (i) are especially suitable as photoinitiators for radical photopolymerization in combination with sensitizers.

In the present text, with the term sensitizer we mean a molecule that, by absorption of UV radiation, does not generate by itself active radicals, but cooperates with the photoinitiator in originating active radical species.

It is therefore a further object of the invention a photopolymerisable system comprising radically photopolimerisable oligomers and/or monomers having ethylenically unsaturated groups, a sensitizer and, as photoinitiator, at least compound of formula I, wherein R has any one of the meaning detailed above but is different from (i).

The useful sensitizers are thioxanthone and its derivatives.

Specific examples of sensitizers suitable in the compositions according to the invention are: thioxanthone, 2-isopropylthioxanthone, mixture of 2-and 4-isopropylthioxanthone, 2-chlorothioxanthone, 2,4-dimethylthioxanthone, 1-chloro-4-propoxythioxanthone, 2-dodecylthioxanthone, 2,4-diethylthioxanthone, 1-methoxycarbonylthioxanthone, 2-ethoxycarbonylthioxanthone, 3- (2-methoxyethoxycarbonyl)-thioxanthone, 4-butoxycarbonylthioxanthone, 3-butoxycarbonyl-7-methylthioxanthone, 1-cyano-3-chlorothioxanthone, 1-ethoxycarbonyl-3-chlorothioxanthone, 1-ethoxycarbonyl-3-ethoxythioxanthone, 1-ethoxycarbonyl-3-amino- thioxanthone, 1-ethoxycarbonyl-3-phenylsulfurylthioxanthone, 3,4-di- [2- (2-methoxyethoxy ethoxycarbonyl]-thioxanthone, 1-ethoxycarbonyl-3-(1-methyl-1-morpholinoethyl)-thioxanthone, 2-methyl-6-dimethoxymethyl-thioxanthone, and mixture thereof.

Thioxanthone, 2-isopropylthioxanthone, mixture of 2-and 4-isopropylthioxanthone 2-chlorothioxanthone, 2,4-dimethylthioxanthone and 1-chloro-4-propoxythioxanthone are the most preferred sensitizer.

The compounds of formula I of the present invention may be prepared by conventional methods which are well known to the man skilled in the art.

In particular, it is possible to react the acyl chloride or thioacyl chloride of formula RY(C=X)Cl with the corresponding hydroxylamine of formula HN(R')OH in an appropriate solvent, such as methylene chloride, in the presence of a base, such as pyridine or triethylamine; generally the reaction is carried out at a temperature between -10°C and 45°C, and preferably at room temperature, for a variable time length, that depends on the reactivity of the reactants. Usually the reaction is completed in 0.5-5 hours. In a second step it is possible to react the hydroxylamine derivative with an acyl chloride to obtain the compounds of formula I.

It is a further object of the present invention a process for the realisation of coatings for metal, wood, paper or plastic surfaces, comprising the application of the photopolymerisable system comprising reactive oligomers and/or monomers having ethylenically unsaturated groups and at least one compound of formula I to obtain, after photopolymerisation, a 0.1 to 100 microns thick coating. The photopolymerisation is carried out with a light source having emission bands in the UV-visible region up to 450 nm.

It is still a further object of the invention a process for the realisation of photolithographic images, preferably on metal surfaces, comprising applying the photopolymerisable system comprising reactive oligomers and/or monomers having ethylenically unsaturated groups, a non reactive polymer (for example a polyacrylate) and at least one compound of formula I.

The formulation is photopolymerized through a negative film with a light source having emission bands in the UV-visible region up to 450 nm to obtain after proper development, an image having a thickness from 0.1 to 3 microns.

Alternatively, the formulation may be polymerized by using a laser ray having suitable wave length (for example 405 nm) and intensity to obtain after proper development, an image having a thickness of from 0.1 to 3 microns.

The term "photopolymerisation" is intended in a wide sense and include, for example, the polymerisation or crosslinking of polymeric materials, such as for example pre-polymers, the homopolymerisation and the copolymerisation of simple monomers and the combination of this kind of reactions.

Monomers useful in the described system include, for example : acrylonitrile, acrylamide and its derivatives, vinyl ethers, N-vinylpyrrolidone, mono and polyfunctional allyl ethers, such as for example trimethylolpropane diallylether, styrenes and alpha-methyl styrenes, esters of acrylic and methacrylic acid with alyphatic alcohols, with glycols, or with polyhydroxylated compounds, as for example pentaerythritol, trimethylolpropane or aminoalcohols, esters of vinyl alcohol with aliphatic or acrylic acids, derivatives of fumaric or maleic acid.

The oligomers which are useful for the present invention include, for example, polyesters, polyacrylates, polyurethanes, epoxidic resins, polyethers with acrylic, maleic or fumaric functionalities.

The compounds of formula I of the present invention acts as photoinitiators and can be used as the sole photoinitiators in the photopolymerisable system of the invention.

In addition to the compounds of formula I, many other components may be included into the photo polymerisable systems of the invention, for example thermal stabilisers, photo-oxydation stabilisers such as sterically hindered amines, antioxidants, oxygen inhibitors, thermal radicals generators such as organic and inorganic peroxides, peresters, hydroperoxides, benzopinacols, azoderivatives such as azodiisobutyronitrile, metallic compounds such as cobalt(II) salts, manganese, antifoams, fillers, dispersing agents, pigments, dyes and/or matting agents, other additives of general use, dispersed solids, glass and carbon fibres, thixotropic agents.

Advantageously, the compounds of formula I, act as photoinitiators in the photocurable composition even in the absence of any hydrogen donor (such as thiols and alcohols).

Chemically inert non photopolymerisable polymers, as for example nitrocellulose, polyacrylic esters, polyolefines etc., or polymers which are crosslinkables with other systems, as for example with peroxides and atmospheric oxygen or acid catalysis or thermal activation, as for example-polyisocyanates, urea, melamine or epoxidic resins are further components that may be included in the photopolymerisable systems.

The compounds of formula I are generally used in the photopolymerisable system in quantity of 0.01 to 20% by weight, preferably of 1 to 6% by weight, on the total weight of the photopolymerisable system and are compatible with the system, imparting to it high photochemical reactivity and heat stability.

The compounds of formula I act as photoinitiators both in clear and in pigmented photopolymerisable systems.

Examples of sources of light useful for the photopolymerisation of the photopolymerisable systems prepared according to the invention are mercury vapour, or superactinic, or metal-halogen iron iodide, or excimers lamps, with emission bands in the UV-visible region and particularly between 180 and 450 nm, or laser lights having suitable wave length (for example 405 nm) and power.

Examples of the preparation of photoinitiators of formula I and of photopolymerisable systems containing them are herein reported, as well as photopolymerisation application tests, not to limit but to illustrate the invention.

### Example 1.

0.756 ml (5.43 mmol) of trietylamine were added to a well stirred suspension of 237 mg (2.78 mmol) of N-methyl hydroxylamine hydrochloride 98% in 20 ml of dichloromethane; after 10' a solution of phenylchlorodithioformate 95% (526 mg, 2.65 mmol) in 5 ml of dichloromethane were added. After 60 minutes at 0°C, the reaction is complete. The organic layer was washed twice with water, dried on Na₂SO₄ and the solvent was removed. An oily residue is obtained which spontaneously crystallises.

530 mg of product were obtained (Intermediate Product 1). Quantitative yield.

1HNMR (CDCl3, 300 MHz, δppm): 10.4(sb, 1H); 7.5(m 5H); 3.7, (s, 3H).

Synthesis of:

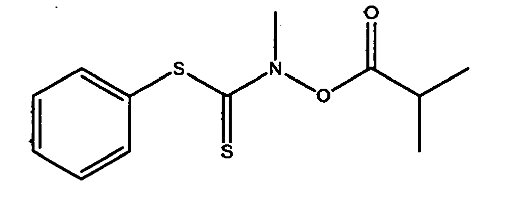

A solution of 0.291 ml (2.76 mmol) of isobutyryl chloride in 5 ml of dichloromethane was added under stirring at 0-5°C to a solution of 500 mg (2.51 mmol) of Intermediate Product 1 and 0.384 ml of triethylamine (2.76 mmol) in 20 ml of dichloromethane. After 1 hour the solution was washed twice with an aqueous diluted solution of sodium bicarbonate, with water and then dried on sodium sulphate and the solvent removed under vacuum.

670 mg of a yellow oil were obtained (yield 99%, 2.49 mmol) 1HNMR (CDCl3, 300MHz, δ ppm): 7.5 (m,5H); 3.6 (s,3H); 2.7 (m,1H); 1.8 (d,6H)

### Example 2.

Synthesis of

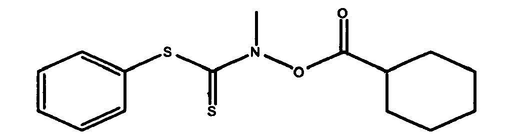

A solution of 0.295 ml (2.21 mmol) of cyclohexylcarbonyl chloride in 5 ml of dichloromethane was added under stirring at 0-5°C to a solution of 400 mg (2.00 mmol) of Intermediate Product 1 (see Ex. 1) and 0.308 ml of triethylamine (2.21 mmol) in 20 ml of dichloromethane. After 1 hour the solution was washed twice with an aqueous diluted solution of sodium bicarbonate, with water, dried on sodium sulphate and the solvent removed under vacuum.

620 mg of a yellow oil were obtained

1HNMR (CDCl3, 300MHz, δ ppm): 7.4 (m,5H); 3.75 (s,3H); 2.5 (m,1H); 2.2-1.1 (m,10H)

### Example 3

Synthesis of:

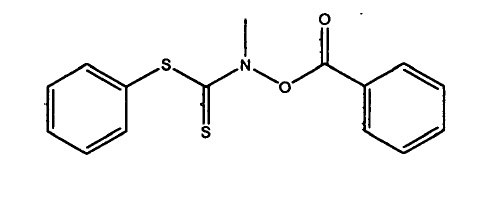

A solution of 0.256 ml (2.21 mmol) of benzoyl chloride in 5 ml of dichloromethane was added under stirring at 0-5°C to a solution of 400 mg (2.00 mmol) of Intermediate Product 1 (see Ex. 1) and 0.308 ml of triethylamine (2.21 mmol) in 20 ml of dichloromethane. After 1 hour the solution was washed twice with an aqueous diluted solution of sodium bicarbonate, with water, dried on sodium sulphate and the solvent removed under vacuum.

610 mg of a yellow oil were obtained

1HNMR (CDCl3, 300MHz, δ ppm): 8.2 (m,2H); 7.8-7.3 (m,8H); 3.9 (s,3H)

### Example 4

Synthesis of

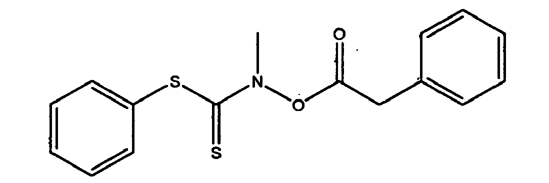

A solution of 0.219 ml (1.655 mmol) of phenylacetyl chloride in 5 ml of dichloromethane was added under stirring at 0-5°C to a solution of 300 mg (1.505 mmol) of Intermediate Product 1 (see Ex. 1) and 0.230 ml of triethylamine (1.655 mmol) in 15 ml of dichloromethane. After 1 hour the solution was washed twice with an aqueous diluted solution of sodium bicarbonate, with water, dried on sodium sulphate and the solvent removed under vacuum.

460 mg of a yellow oil were obtained (yield 96%)

1HNMR (CDCl3, 300MHz, δppm): 7.4 (m,10H); 3.9 (s,2H); 3.755 (s,3H)

### Example 5

Synthesis of: 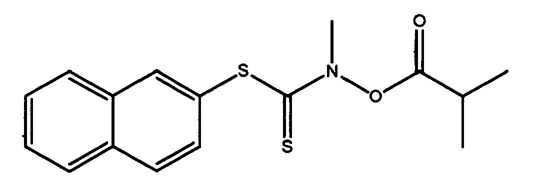
a) In 15', 4.99 g (12.48 mmol) of NaOH 10% were added under stirring to a solution of 2 g (12.48 mmol) of 2-naphthalenthiol and 1.48 g of thiophosgene 97% (12.48 mmol) kept at 15-20°C. After 1 hour 25.6 ml of dichloromethane and 12.8 ml of water were added, the organic phase is separated and washed with water, dried on sodium sulphate and the solvent is removed under vacuum.
   An oily product is obtained that, when treated with petroleum ether,crystallysed.
   2.32 g of a yellow solid were obtained (Intermediate Product 2) Yield 77%.
b) 2.84 ml (20.37 mmol) of triethylamine were added at 0°C to a suspension of 852.7 mg (10.21 mmol) of N-methylhydroxylamine chlorohydrate in dichloromethane; after 10' a solution of 2.32 g (9.72 mmol) of Intermediate Product 2 in 20 ml of dichlormethane was added. After 1 hour the solution was washed with water, dried on sodium sulphate and the solvent removed under vacuum. The crude product was purified by flash chromathography (eluent: dichloromethane)
   1.7 g of a whitish solid were obtained (Intermediate Product 3). Yield 70%.
   1HNMR (CDCl3, 300MHz, δppm): 8.07 (s,1H); 7.88 (m,3H); 7.55 (m,3H); 3.78 (s, 3H)
c) A solution of 0.186 ml (1.76 mmol) of isobutyryl chloride in 5 ml of dichloromethane was added dropwise at 0-5°C to a solution of 400 mg (1.6 mmol) of Intermediate Product 3 and 0.245 ml of triethylamine (1.76 mmol) in 20 ml of dichloromethane. After 15', the solution was washed twice with a 5% solution of sodium bicarbonate, dried on sodium sulphate and the solvent removed under vacuum. An oily residue is obtained which spontaneously crystallises.
   The solid was treated with petroleum ether, filtered and dried.
   420 mg of a yellow solid were obtained (yield 82%).
   1HNMR (CDCl3, 300MHz, δppm): 8.00 (s,1H); 7.85 (m,3H); 7.52 (m,3H); 3.7 (s, 3H); 2.85 (m, 1H); 1.4 (d, 6h)

### Example 6

Synthesis of:

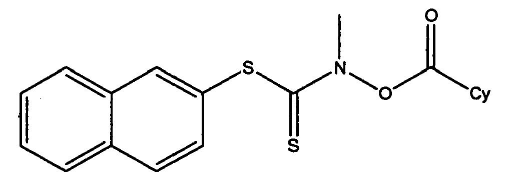

A solution of 0.235 ml (1.76 mmol) of cyclohexylcarbonyl chloride in 5 ml of dichloromethane was added dropwise at 0-5°C to a solution of 400 mg (1.6 mmol) of Intermediate Product 3 (see Ex. 5) and 0.245 ml of triethylamine (1.76 mmol) in 20 ml of dichloromethane. After 15', the solution was washed twice with a 5% solution of sodium bicarbonate, dried on sodium sulphate and the solvent removed under vacuum.

An oily residue was obtained which spontaneously crystallises.

The solid was treated with petroleum ether, filtered and dried.

470 mg of a yellow solid were obtained (yield 82%).

1HNMR (CDCl3, 300MHz, δppm): 8.00 (s,1H); 7.85 (m,3H); 7.82 (m,3H); 3.80 (s, 3H); 2.60 (m, 1H); 2.2-1.1 (m, 10H)

### Example 7

Synthesis of

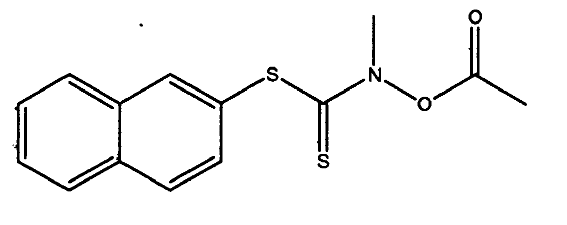

A solution of 0.125 ml (1.76 mmol) of acetylchloride in 5 ml of dichloromethane was added dropwise at 0-5°C to a solution of 400 mg (1.6 mmol) of Intermediate Product 3 (see Ex 5) and 0.245 ml of triethylamine (1.76 mmol) in 20 ml of dichloromethane. After 15', the solution was washed twice with a 5% solution of sodium bicarbonate, dried on sodium sulphate and the solvent removed under vacuum. An oily residue was obtained which spontaneously crystallises.

The solid was treated with petroleum ether, filtered and dried.

440 mg of a whitish solid were obtained (yield 94%).

1HNMR (CDCl3, 300MHz, δppm): 8.00 (s,2H); 7.86 (m,3H); 7.50 (m,3H); 3.80 (s, 3H); 2.45 (s, 3H)

### Example 8

Synthesis of:

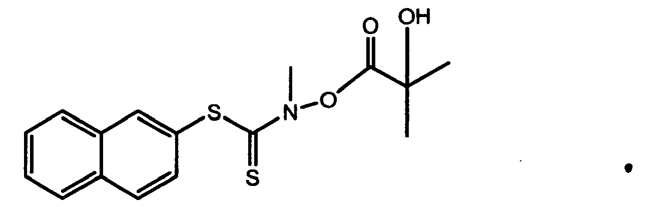

A solution of 925 mg (4.48 mmol) of N-N'-dicyclohexylcarbodiimide (DCC) in 10 ml of THF was added at 0°C to a solution of 466 mg (4.48 mmol) of 2-hydroxy-2-methylpropanoic acid and 932 mg (3.74 mmol) of Intermediate Product 3 (see Ex. 5) in 20 ml of THF. After 5 hours at room temperature, the product was filtered and the solvent removed under vacuum.

The product was purified by flash chromatography (eluent: petroleum ether/AcOEt 7/3).The solid was treated with petroleum ether, filtered and dried.

300 mg of a white solid were obtained (yield 24%).

1HNMR (CDCl3, 300MHz, δppm): 8.01 (s,1H); 7.88 (m,3H); 7.55 (m,3H); 3.85 (s, 3H); 1.70 (s, 6H)

### Example 9

Synthesis of:

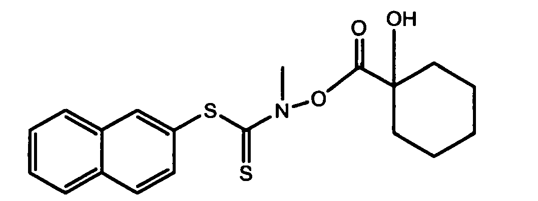

792 mg (3.18 mmol) of Intermediate Product 3 (see Ex. 5) and 560 mg of N-hydroxybenzotriazole 87% were added to a solution of 550 mg (3.82 mmol) of 1-hydroxycyclohexanecarboxylic acid in 20 ml of THF. The solution was cooled to 0°C and 788 mg (3.82 mmol) of DCC in 10 ml of THF were added dropwise. After 1 night at room temperature, the reaction was filtered, washed with a 0.5% sodium hydroxide solution. The organic phase was dried on sodium sulphate and the solvent removed under vacuum.

The product was purified by flash chromatography (eluent: petroleum ether/AcOEt 8/2). 123 mg of a yellow product were obtained (yield 8%).

1HNMR (DMSO, 300MHz, δppm): 8.10 (s,1H); 8.00 (m,3H); 7.61 (m,2H); 7.41 (d, 1H); 5.81 (s, 1H); 3.72 (s, 3H); 1.1-2.1 (m, 10H)

### Example 10

Synthesis of: 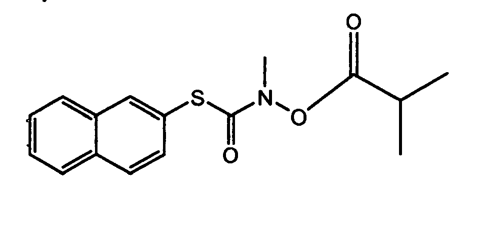
a) 1.39 g (13.73 mmol) of triethylamine and, at 0°C, a solution of 1.3 g (4.37 mmol) of triphosgene in 5 ml of dichoromethane were added to a solution of 2 g (12.48 mmol) of 2-thionaphthol in 15 ml of dichloromethane.
   At the end of the addition the reaction was kept for two hours at room temperature, filtered and the solvent was removed under vacuum. The product was used as such in the next step.
b) 3.65 ml (26.21 mmol) of triethylamine were added at 0°C to a suspension of 1.094 g (13.1 mmol) of N-Methylhydroxylamine hydrochloride in 100 ml of dichloromethane; after complete dissolution, 2.78 g (12.48 mmol) of the product obtained in step a) were added. After the addition, the reaction was kept for 3 hours at room temperature. The organic phase was washed with water, dried on sodium sulphate and the solvent removed under vacuum. The crude product was purified by flash chromathography (eluent: dichloromethane/AcOEt 95/5). An oil was obtained which spontaneously crystallised giving 420 mg of a whitish solid. Yield 14%.
   1HNMR (CDCl3, 300MHz, δppm): 8.02 (s,1H); 7.85 (m,3H); 7.51 (m,3H); 6.71(sb, 1H); 3.30 (s, 3H)
c) 0.27 ml (1.94 mmol) of triethylamine were added to a solution of 410 mg (1.76 mmol) of the product obtained in the previous step in dichloromethane; the temperature was lowered to 0-5°C and a solution of 0.205 ml (1.95 mmol) of isobutyryl chloride in 5 ml of dichloromethane was added. After 15', the organic phase was washed with water, dried on sodium sulphate, filtered and the solvent removed under vacuum.
   The oily residue crystallised after treatment with petroleum ether. The solid was filtered and dried under vacuum at room temperature. 400 mg of a whitish solid were obtained (yield 75%).
   1HNMR (CDCl3, 300MHz, δppm): 8.01 (s,1H); 7.85 (m,3H); 7.52 (m,3H); 3.38 (s, 3H); 2.80 (m, 1H); 1.35 (d, 6h)

### Example 11

Synthesis of: 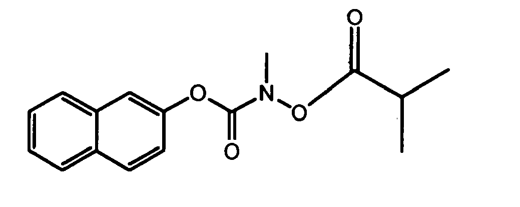
a) 2.12 ml (15.26 mmol) of triethylamine and, at 0°C, a solution of 1.44 g (4.85 mmol) of triphosgene in 5 ml of dichoromethane were added to a solution of 2 g (13.87 mmol) of 2-naphthol in 15 ml of dichloromethane.
   At the end of the addition the reaction was kept for two hours at room temperature, and filtered. The solution was used as such in the next step.
b) 4.03 ml (28.98 mmol) of triethylamine were added under stirring at 0°C to a suspension of 1.21 g (14.49 mmol) of N-methylhydroxylamine hydrochloride in 100 ml of dichloromethane; after complete dissolution, 2.86 g of the product obtained in step a) (13.8 mmol calculated) were added. After 3 hours at room temperature, the organic phase was washed with water, dried on sodium sulphate and the solvent removed under vacuum. The crude product was purified by flash chromathography (eluent: dichloromethane/AcOEt 95/5). 470 mg of a reddish solid were obtained. Yield 15.6%.
c) 0.324 ml (2.33 mmol) of triethylamine were added to a solution of 460 mg (2.12 mmol) of the product obtained in the previous step in 20 ml of dichloromethane; the temperature was lowered to 5°C and a solution of 0.246 ml (2.33 mmol) of isobutyryl chloride in 5 ml of dichloromethane was added. After 15', the organic phase was washed with water, dried on sodium sulphate, filtered and the solvent removed under vacuum.
   490 mg of a solid were obtained (yield 80%).
   1HNMR (CDCl3, 300MHz, δppm): 8.01 (s,1H); 7.85 (m,3H); 7.52 (m,3H); 3.38 (s, 3H); 2.80 (m, 1H); 1.35 (d, 6H)

### Example 12

Synthesis of: 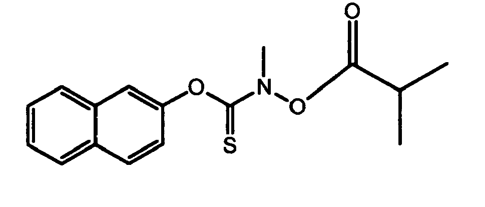
a) 1.81 g (15.26 mmol) of thiophosgene were added to a solution of 2 g (13.87 mmol) of 2-naphthol in 25 ml of dichloromethane.
   The temperature was brought to 15°C and dropwise 6.1 g of 10% NaOH were added.
   After 45' 15 ml of dichloromethane and 14 ml of water were added, The organic phase was separated and washed twice with water, dried on sodium sulphate and filtered.
   The solution was used as such in the next step.
b) 4.05 ml (29.13 mmol) of triethylamine were added at 0°C to a suspension of 1.216 g (14.56 mmol) of N-methylhydroxylamine hydrochloride in 100 ml of dichloromethane; the solution obtained in step a) was added. The reaction was kept for 2 hours at room temperature. The organic phase was washed twice with water, dried on sodium sulphate and the solvent removed under vacuum. 3 g of solid were obtained and purified by flash chromathography.
   2.24 g of a yellow solid were obtained. Yield 69%.
   1HNMR (CDCl3, 300MHz, δppm): 7.85 (m,3H); 7.50 (m,3H); 7.30 (m,1H); 3.70 (s, 3H)
c) 1.46 ml (10.47 mmol) of triethylamine were added to a solution of 2.22 g of the product obtained in the previous step in 50 ml of dichloromethane; the temperature was lowered to 5°C and a solution of 1.1 ml (10.47 mmol) of isobutyryl chloride was added. After 15', the organic phase was washed twice with water, dried on sodium sulphate, filtered and the solvent removed under vacuum.
   The oily residue crystallised after treatment with petroleum ether. 1.53 g of a yellowish solid were obtained (yield 53%).
   1HNMR (CDCl3, 300MHz, δppm): 7.80 (m,3H); 7.48 (m,3H); 7. 20 (m,1H); 3.75 (s, 3H); 2.78 (m, 1H); 1.28 (d, 6h)

### Example 13

Synthesis of: 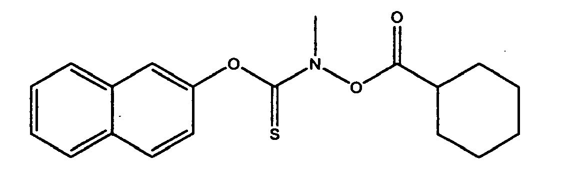
a) 2.91 ml (38.15 mmol) of thiophosgene and, at 15°C, dropwise, a solution of 13.77 ml of 10% NaOH were added to a solution of 5 g (34.68 mmol) of 2-naphthol in 100 ml of dichloromethane.
   After 45 minutes the product was washed with water, the organic phase separated and washed twice with water, dried on sodium sulphate and filtered.
   The solution was used as such in the next step.
b) 9.7 ml (69.36 mmol) of triethylamine were added at 0°C to a suspension of 3.04 g (36.41 mmol) of N-methylhydroxylamine hydrochloride in 100 ml of dichloromethane; the solution obtained in step a) was added. After the addition, the reaction was kept for 2 hours at room temperature. The organic phase was washed twice with water, dried on sodium sulphate, filtered and the solvent removed under vacuum.
   2.8 g of a yellowish solid were obtained. Yield 69%.
   1HNMR (CDCl3, 300MHz, δppm): 7.85 (m,3H); 7.50 (m,3H); 7.30 (m, 1H); 3.70 (s, 3H)
c) 0.92 ml of triethylamine were added to a solution of 1.4 g (6.08 mmol) of the product obtained in the previous step dissolved in 25 ml of dichloromethane; the temperature was lowered to 0°C and a solution of 0.894 ml of cyclohexylcarbonyl chloride in 10 ml of dichloromethane were added dropwise. After 15', the organic phase was washed twice with sodium bicarbonate, dried on sodium sulphate, filtered and the solvent removed under vacuum.
   1.5 g of a yellow oil were obtained.
   1HNMR (CDCl3, 300MHz, δppm): 7.82 (m,3H); 7.48 (m,3H); 7.20 (m,1H); 3.75 (s, 3H); 2.55 (m, 1H); 2.1-1.2 (m, 10H)

### Application examples.

### Photopolymerisation experiments

### Reactivity evaluation by real time FT-IR

The photopolymerizable systems were prepared by dissolving 1% weight of photoinitiator in Ebecryl 605 (epoxyacrylate + TPGDA) and possibly (see Table 1) 1% of isopropylthioxanthone (ITX) as sensitizer.

Because of the monomer viscosity, the formulations were heated between 40 and 50°C during 15 minutes to 3 hours in order to complete the dissolution. After half a day at room temperature (to remove the air bubbles trapped in the formulations) they were stored in the refrigerator.

The photopolymerization experiments were carried out in laminated according to the following procedure: a small amount of the formulation was put between two polypropylene films to avoid the effect of oxygen on the polymerization and pressed in order to reach an IR absorption between 1.2 and 1.6 at 1635 cm⁻¹.

The film was then placed between two BaF₂ windows in a real time FTIR (Nexus 870, Nicolet) and spectra were recorded countinously. The film was irradiated by a Hg-Xe Hamamatsu lamp (10% of the full intensity without any filter to select the irradiation wavelenghth) during 5 minutes. A delay of 2-3 seconds was introduced after the start of the IR spectra registration.

The kinetic curves were calculated by integrating the IR band characteristic of an acrylate double bond in the monomer between 1625 and 1655 cm⁻¹.

In the Table 1 "Rp" is the rate of polymerization and "Conv" the quantity of double bond reacted and converted into polymer.

Rp is reported as relative rate of polymerization using 2,2-dimethoxy-2-phenylacetophenone (DMPA) as reference. Rp (DMPA) is taken as 100 in column 3 and 4 and 75 in column 1 and 2.

**Tab. 1 - Rate of polymerization and conversion.**

| | Laminated Col. 1 | | air Col. 2 | | ITX 1% Laminated Col.3 | | ITX 1% air Col.4 | |
|---|---|---|---|---|---|---|---|---|
| Es. | Rp | Conv % | Rp | Conv % | Rp | Conv % | Rp | Conv % |
| 3 | 1.73 | 54 | | | 6 | 87 | | |
| 5 | 51 | 67 | | | 100 | 73 | 97 | 69 |
| 6 | 37 | 84 | 26 | 66 | 59 | 85 | 52 | 81 |
| 7 | 7.4 | 59 | | | | | | |
| 8 | 6 | 65 | | | 17 | 72 | 18 | 74 |
| 9 | 14 | 63 | 14 | 48 | 70 | 76 | 32 | 76 |
| 10 | 5 | 49 | | | 16 | 73 | | |
| 11 | 1 | 27 | | | 8 | 72 | | |
| 12 | 35 | 65 | 33 | 43 | 109 | 75 | 99 | 68 |

## Claims

1. Photopolymerisable systems comprising radically photopolimerisable oligomers and/or monomers having ethylenically unsaturated groups and, as photoinitiator, at least one compounds of formula (I) 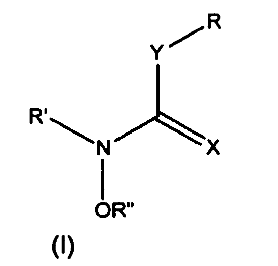 wherein
X and Y are independently of each other O or S;
R is phenyl or phenyl which is substituted by one or more radicals C₁-C₁₂ linear or branched alkyl or C₅-C₈ cycloalkyl, C₁-C₄-haloalkyl, halogen, nitro, cyano, phenyl, benzyl, OR₀, NR₁R₂, SR₃, benzoyl, S(=O)-phenyl, S(=O)₂-phenyl and/or-S-phenyl, the substituents OR₀, NR₁R₂, SR₃, possibly forming 5- or 6-membered rings via the radicals R₀,R₁,R₂, and/or R₃, with further substituents on the phenyl ring or with one of the carbon atoms of the phenyl ring,
or R is 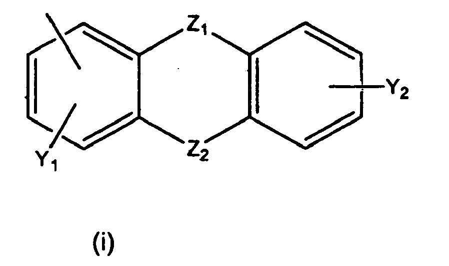 where Z₁ and Z₂, are independently of each other single bond, S, O, S=O, S(=O)₂, C=O, C=S, NR₁, C(=N)R₁, C₁-C₂ alkylene which may be unsubstituted or substituted by a C₁-C₁₂ alkyl, and Y₁ and Y₂, are independently of each other C₁-C₁₂ linear o branched alkyl, C₁-C₄-haloalkyl, cycloalkyl, halogen, phenyl, benzyl, OR₀, NR₁R₂, SR₃, benzoyl, S(=O)-phenyl, S(=O)₂-phenyl and/or-S-phenyl, the substituents OR₀, NR₁R₂, SR₃ possibly forming 5- or 6-membered rings via the radicals R₀,R₁,R₂ and/or R₃, with further substituents on the phenyl aromatic ring or with one of the carbon atoms of the aromatic ring,
or R is naphthyl, anthracyl, phenanthryl, the radicals naphthyl, anthracyl and phenanthryl being unsubstituted or substituted by one or more linear or branched C₁-C₆ alkyl or or C₅-C₈ cycloalkyl, phenyl, OR₀, NR₁R₂, SR₃ and/or S-phenyl, the substituents OR₀, NR₁R₂, SR₃ possibly forming 5- or 6-membered rings via the radicals Ro, R₁, R₂ and/or R₃, with further substituents on the naphthyl, anthracyl or phenanthryl ring or with one of the carbon atoms of the naphthyl, anthracyl or phenanthryl ring,
or R is a 5- or 6-membered heterocyclic unstaurated radical comprising one or two heteroatoms selected among O, S and N, which is unsubstituted or substituted by C₁-C₆ alkyl, phenyl, OR₀, NR₁R₂, SR₃ and/or S-phenyl, the substituents OR₀, NR₁R₂, SR₃ possibly forming 5-or 6-membered rings via the radicals R₀, R₁, R₂ and/or R₃ with further substituents on the heterocyclic unstaurated radical or with one of the carbon atoms of the heterocyclic unstaurated radical;
R' is a C₁-C₁₂ linear or branched alkyl group or C₅-C₈ cycloalkyl, unsubstituted or substituted by OH, C₁-C₄ alkoxy, SH, NR₁R₂, phenyl, benzyl, benzoyl, C₁-C₁₂ alkylsulfonyl, phenylsulfonyl, (4-methylphenyl)sulfonyl and/or C₁-C₆ alkanoyl, or C₅-C₈ cycloalkyl,
or R' is C₂-C₁₂ alkyl interrupted by one or more -O-, said interrupted C₂-C₁₂ alkyl being unsubstituted or substituted by OH,C₁-C₄ alkoxy, C₁-C₁₂ alkylsulfonyl, phenylsulfonyl, (4-methylphenyl)sulfonyl and/or C₁-C₆ alkanoyl,
or R' is phenyl, or phenyl which is substituted by one or more radicals C₁-C₁₂ alkyl or C₅-C₈ cycloalkyl, C₁-C₄-haloalkyl, halogen, phenyl, OR₀, NR₁R₂, SR₃, benzoyl, S(=O)-phenyl, S(=O)₂-phenyl and/or-S-phenyl, the substituents OR₀, NR₁R₂, SR₃ possibly forming 5- or 6-membered rings via the radicals R₀,R₁,R₂ and/or R₃ with further substituents on the phenyl ring or with one of the carbon atoms of the phenyl ring;
R" has one of the meaning of R',
or R" is (C=O)R"', and R"' has one of the meaning of R';
R₀ is hydrogen, phenyl, benzyl, C₁-C₁₂ alkyl or or C₅-C₈ cycloalkyl, which are unsubstituted or substituted by phenyl, benzyl, benzoyl, OH, C₁-C₁₂ alkoxy, C₁-C₁₂ alkylsulfonyl, phenylsulfonyl, (4-methylphenyl)sulfonyl and/or by C₂-C₆-alkanoyl,
or R₀ is C₂-C₁₂ alkyl interrupted by one or more -O-, said interrupted C₂-C₁₂ alkyl being unsubstituted or substituted by phenyl, OH, C₁-C₄ alkoxy, C₁-C₁₂ alkylsulfonyl, phenylsulfonyl, (4-methylphenyl)sulfonyl and/or by C₂-C₆ alkanoyl;
R₁ and R₂ independently of one another are hydrogen, C₁-C₁₂ alkyl which is unsubstituted or substituted by OH, C₁-C₄ alkoxy, C₁-C₁₂ alkylsulfonyl, phenylsulfonyl, (4-methylphenyl)sulfonyl and/or C₁-C₆alkanoyl;
or R₁ and R₂ are C₂-C₁₂ alkyl or cycloalkyl interrupted by one or more -O-, said interrupted C₂-C₁₂ alkyl being unsubstituted or substituted by OH, C₁-C₄ alkoxy, C₁-C₁₂ alkylsulfonyl, phenylsulfonyl, (4-methylphenyl)sulfonyl and/or C₁-C₆ alkanoyl,
or R₁ and R₂ are phenyl, C₂-C₆alkanoyl, benzoyl, C₁-C₆ alkylsulfonyl, phenylsulfonyl, (4-methylphenyl)sulfonyl, naphthylsulfonyl, anthracylsulfonyl or phenanthrylsulfonyl,
or R₁ and R₂, together with the nitrogen atom to which they are bonded, form a 5-, 6- or 7-membered ring which may be interrupted by -O-, -S- or by -NR₀-;
R₃ is C₁-C₁₂ alkyl or C₅-C₈ cycloalkyl which is unsubstituted or substituted by OH and/or C₁-C₄alkoxy
or R₃ is C₂-C₁₂ alkyl interrupted by one or more -O-, said interrupted C₂-C₁₂ alkyl being unsubstituted or substituted by OH and/or C₁-C₄alkoxy.

2. Photopolymerisable systems according to claim 1. wherein R is naphthyl, the naphthyl radical being unsubstituted or substituted by one or more linear or branched C₁-C₆ alkyl or C₅-C₈ cycloalkyl, phenyl, OR₀, NR₁R₂, SR₃ and/or S-phenyl, the substituents OR₀, NR₁R₂, SR₃ possibly forming 5- or 6-membered rings via the radicals R₀, R₁, R₂ and/or R₃, with further substituents on the naphthyl ring or with one of the carbon atoms of the naphthyl ring,
or R is phenyl or phenyl which is substituted by one ore more of the radicals C₁-C₁₂ linear or branched alkyl or C₅-C₈ cycloalkyl, C₁-C₄-haloalkyl, halogen, nitro, cyano, phenyl, benzyl, OR₀, NR₁R₂, SR₃, benzoyl, S(=O)-phenyl, S(=O)₂-phenyl and/or-S-phenyl, the substituents OR₀, NR₁R₂, SR₃, possibly forming 5- or 6-membered rings via the radicals. R₀,R₁,R₂, and/or R₃, with further substituents on the phenyl ring or with one of the carbon atoms of the phenyl ring;
R' is a C₁-C₆ linear or branched alkyl group or C₅-C₈ cycloalkyl,
and R" is (C=O)R"'.

3. Photopolymerisable systems according to claim 2. wherein R is phenyl or naphthyl and R' is methyl.

4. Compound of formula (I) wherein X and Y are S, R is naphthyl, R' is methyl; and R" is (C=O)R'" with R"' isopropyl.

5. Compound of formula (I) wherein X and Y are S, R is naphthyl, R' is methyl; and R" is (C=O)R"' with R"' cyclohexyl.

6. Photopolymerisable systems according to claim 1 comprising as photoinitiator, at least compound of formula I wherein X, Y, R, R' e R" has any one of the meaning detailed in claim 1 with the proviso that R is different from (i).

7. Photopolymerisable system according to claim 6. in which the sensitizer is chosen among: thioxanthone, 2-isopropylthioxanthone, mixture of 2-,4-isopropylthioxanthone, 2-chlorothioxanthone, 2-dodecylthioxanthone, 2,4-diethylthioxanthone, 2,4-dimethylthioxanthone, 1-chloro-4-propoxythioxanthone, 1-methoxycarbonylthioxanthone, 2-ethoxycarbonylthioxanthone, 3- (2-methoxyethoxycarbonyl)-thioxanthone, 4-butoxycarbonylthioxanthone, 3-butoxycarbonyl-7-methylthioxanthone, 1-cyano-3-chlorothioxanthone, 1-ethoxycarbonyl-3-chlorothioxanthone, 1-ethoxycarbonyl-3-ethoxythioxanthone, 1-ethoxycarbonyl-3-amino- thioxanthone, 1-ethoxycarbonyl-3-phenylsulfurylthioxanthone, 3,4-di- [2- (2-methoxyethoxy ethoxycarbonyl]-thioxanthone, 1-ethoxycarbonyl-3- (1-methyl-1-morpholinoethyl)-thioxanthone, 2-methyl-6-dimethoxymethyl-thioxanthone, and mixture thereof.

8. Photopolymerisable system according to claim 6. in which the sensitizer is chosen among: thioxanthone, 2-isopropylthioxanthone, mixture of 2-,4-isopropylthioxanthone, 2-chlorothioxanthone, 2,4-dimethylthioxanthone and 1-chloro-4-propoxythioxanthone.

9. Process for the realisation of coatings for metal, wood, paper or plastic surfaces, comprising: a) applying the photopolymerisable system comprising reactive oligomers and/or monomers having ethylenically unsaturated groups and at least one compound of formula I 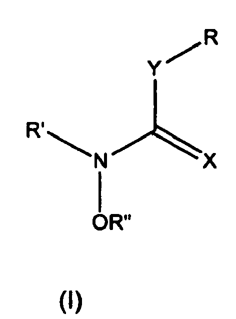 wherein X, Y, R, R' e R" has any one of the meaning detailed in claim 1
b) photopolymerising with a light source having emission bands in the UV-visible region up to 450 nm to obtain, after polymerisation, a 0.1 to 100 microns thick coating.

10. Process for the realisation of photolithographic images, preferably on metal surfaces, comprising: a) applying the photopolymerisable system comprising reactive oligomers and/or monomers having ethylenically unsaturated groups, a non reactive polymer such as a non rective polyacrylate and at least one compound of formula I 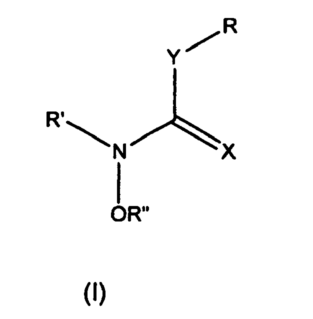 wherein X, Y, R, R' e R" has any one of the meaning detailed in claim 1; b) photopolymerizing through a negative film with a light source having emission bands in the UV-visible region up to 450 nm or with a laser light having suitable wavelength (i.e. 405 nm) and power to obtain after proper development, an image having a thickness of from 0.1 to 3 microns.

## Patentansprüche

1. Photopolymerisierbare Systeme, die radikalisch photopolymerisierbare Oligomere und/oder Monomere mit ethylenisch ungesättigten Gruppen und als Photoinitiator mindestens eine Verbindung der Formel (I) enthalten: 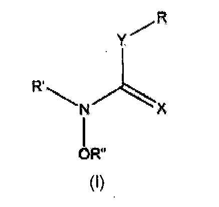 worin
X und Y voneinander unabhängig O oder S sind;
R ein Phenyl oder ein Phenyl ist, das durch ein oder mehrere lineare oder verzweigte C₁-C₁₂ Alkylradikale oder C₅-C₈ Zykloalkyl, C₁-C₄ Haloalkyl, Halogen, Nitro, Cyano, Phenyl, Benzyl, OR₀, NR₁R₂, SR₃, Benzoyl, S(=O)-Phenyl, S(=O)₂-Phenyl und/oder S-Phenyl substituiert wurde, wobei die Substituenten OR₀, NR₁R₂, SR₃ möglichst Fünf- oder Sechsringe durch die Radikale R₀,R₁,R₂ und/oder R₃ mit weiteren Substituenten am Phenylring oder mit einem der Kohlenstoffatome des Phenylrings bilden,
oder R ein 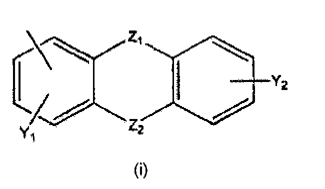 ist, in dem Z₁ und Z₂ unabhängig voneinander Einfachbindung, S, O, S=O, S(=O)₂, C=O, C=S, NR₁, C(=N)R₁, C₁-C₂ Alkylen ist, die durch ein C₁-C₁₂ Alkyl unsubstituiert oder substituiert werden können, und Y₁ und Y₂ unabhängig voneinander lineare oder verzweigte C₁-C₁₂ Alkyl, C₁-C₄-Haloalkyl, Zykloalkyl, Halogen, Phenyl, Benzyl, OR₀, NR₁NR₂, SR₃, Benzoyl, S(=O)-Phenyl , S(=O)₂-Phenyl und/oder S-Phenyl sind, wobei die Substituenten OR₀, NR₁R₂, SR₃ möglichst Fünf- oder Sechsringe durch die Radikale R₀R₁R₂ und/oder R₃ mit weiteren Substituenten am aromatischen Phenylring oder mit einem der Kohlenstoffatome des aromatischen Rings bilden,
oder R ein Naphtyl, Anthracyl, Phenanthryl ist, wobei die Radikale Anthracyl und Phenanthryl unsubstituiert oder substituiert werden durch ein oder mehrere lineare oder verzweigte C₁-G₆ Alkyle oder C₅-C₈ Zykloalkyl, Phenyl, OR₀, NR₁R₂, SR₃ und/oder S-Phenyl und die Substituenten OR₀, NR₁R₂, SR₃ möglichst einen Fünf- oder Sechsring durch die Radikale R₀, R₁, R₂ und/oder R₃ mit weiteren Substituenten am Naphtyl-, Anthracyl- oder Phenanthrylring oder mit einem der Kohlenstoffatome des Naphtyl-, Anthracyl- oder Phenanthrylrings bilden,
oder R ein heterozyklisches ungesättigtes Fünf- oder Sechsring Radikal ist, das ein oder zwei Heteroatome enthält, die aus O, S und N ausgewählt wurden, das durch C₁-C₁₆ Alkyl, Phenyl, OR₀, NR₁R₂, SR₃ und/oder S-Phenyl unsubstituiert oder substituiert wird, wobei die Substituenten OR₀, NR₁R₂, SR₃ möglichst einen Fünf - oder Sechsring durch die Radikale R₀, R₁, R₂ und/oder R₃ mit weiteren Substituenten am heterozyklischen ungesättigten Radikal oder mit einem der Kohlenstoffatome des heterozyklischen ungesättigten Radikals bilden;
R' eine lineare oder verzweigte C₁-C₁₂ Alkylgruppe oder ein durch OH unsubstituiertes oder substituiertes C₅-C₈ Zykloalkyl, ein C₁-C₄ Alkoxy, SH, NR₁R₂, Phenyl, Benzyl, Benzoyl, C₁-C₁₂ Alkylsulfonyl, Phenylsulfonyl, (4-Methylphenyl)sulfonyl und/oder C₁-C₆ Alkanoyl oder C₅-C₈ Zykloalkyl ist,
oder R' ein durch ein oder mehrere -O- unterbrochenes C₂-C₁₂ Alkyl ist, wobei besagtes unterbrochenes C₂-C₁₂ Alkyl durch OH, C₁-C₄ Alkoxy, C₁-C₁₂ Alkylsulfonyl, Phenylsulfonyl, (4-Methylphenyl)sulfonyl und/oder C₁-C₆ Alkanoyl unsubstituiert oder substituiert wird,
oder R' ein Phenyl, oder ein durch ein oder mehrere C₁-C₁₂ Alkyl- oder C₅-C₈ Zykloalkylradikale, C₁-C₄Haloalkyl, Halogen, Phenyl, OR₀, NR₁R₂, SR₃, Benzoyl, S(=O)-Phenyl, S(=O)₂-Phenyl und/oder S-Phenyl substituiertes Phenyl ist und die Substituenten OR₀, NR₁R₂, SR₃ möglichst einen Fünf- oder Sechsring durch die Radikale Ro, R₁, R₂ und/oder R₃ mit weiteren Substituenten am Phenylring oder mit einem der Kohlenstoffatome am Phenylring bilden;
R" eine der Bedeutungen von R' hat,
oder R" ein (C=O)R"' ist und R"' eine der Bedeutungen von R' hat;
R₀ ein Sauerstoff, Phenyl, Benzyl, C₁-C₁₂ Alkyl oder C₅-C₈ Zykloalkyl ist, das durch Phenyl, Benzyl, Benzoyl, OH, C₁-C₁₂ Alkoxy, C₁-C₁₂ Alkylsulfonyl, Phenylsulfonyl, (4-Methylphenyl)sulfonyl und/oder C₂-C₆ Alkanoyl unsubstituiert oder substituiert wird,
oder R₀ ein durch ein oder mehrere -O- unterbrochenes C₂-C₁₂ Alkyl ist und besagtes unterbrochenes C₂-C₁₂ Alkyl durch Phenyl, OH, C₁-C₄ Alkoxy, C₁-C₁₂ Alkylsulfonyl, Phenylsulfonyl, (4-Methylphenyl)sulfonyl und/oder durch C₂-C₆ Alkanoyl unsubstituiert oder substituiert wird;
R1 und R2 unabhängig voneinander Wasserstoff, C₁-C₁₂ Alkyl ist, das durch OH, C₁-C₄ Alkoxy, C₁-C₁₂ Alkylsulfonyl, Phenylsulfonyl, (4-Methylphenyl)sulfonyl und/oder C₁-C₆ Alkanoyl unsubstituiert oder substituiert wird;
oder R₁ und R₂ durch ein oder mehrere -O- unterbrochene C₂-C₁₂ Alkyle oder Zykloalkyle sind und besagtes C₂-C₁₂ Alkyl durch OH, C₁-C₄ Alkoxy, C₁-C₁₂ Alkylsulfonyl, Phenylsulfonyl, (4-Methylphenyl)sulfonyl und/oder C₁-C₆ Alkanoyl unsubstituiert oder substituiert wird,
oder R₁ und R₂ Phenyl, C₂-C₆ Alkanoyl, Benzoyl, C₁-C₆ Alkylsulfonyl, Phenylsulfonyl, (4-Methylphenyl)sulfonyl, Naphthylsulfonyl, Anthracylsulfonyl oder Phenanthrylsulfonyl sind, oder R₁ und R₂ zusammen mit dem Stickstoffatom, an das sie gebunden sind, einen Fünf-, Sechs- oder Siebenring bilden, der durch -O-, -S-, oder-NR₀- unterbrochen sein kann;
R₃ ein C₁-C₁₂ Alkyl oder C₅-C₇₈ Zykloalkyl ist, das durch OH und/oder C₁-C₄ Alkoxy unsubstituiert oder substituiert wird
oder R₃ ein durch ein oder mehrere -O- unterbrochenes C₂-C₁₂ Alkyl ist und besagtes unterbrochenes C₂-C₁₂ Alkyl durch OH und/oder C₁-C₄ Alkoxy unsubstituiert oder substituiert wird.

2. Photopolymerisierbare Systeme gemäß Patentanspruch 1, worin R ein Naphthyl ist und das Naphthylradikal durch ein oder mehrere lineare oder verzweigte C₁-C₆ Alkyle oder C₅-C₈ Zykloalkyl, Phenyl, OR₀. NR₁R₂, SR₃ und/oder S-Phenyl unsubstituiert oder substituiert wird, wobei die Substituenten OR₀, NR₁R₂, SR₃ möglichst Fünf- oder Sechsringe durch die Radikale R₀, R₁, R₂ und/oder R₃ mit weiteren Substituenten am Naphthylring oder mit einem der Kohlenstoffatome des Naphthylrings bilden,
oder R ein Phenyl oder ein Phenyl ist, das durch eines oder mehrere der linearen oder verzweigten C₁-C₁₂ Alkylradikale oder C₅-C₈ Zykloalkyl, C₁-C₄ Haloalkyl, Halogen, Nitro, Cyano, Phenyl, Benzyl, OR₀, NR₁R₂, SR₃, Benzoyl, S(=O)-Phenyl, S(=O)₂-Phenyl und/oder S-Phenyl substituiert wird, wobei die Substituenten OR₀, NR₁R₂, SR₃ möglichst einen Fünf- oder Sechsring durch die Radikale R₀,R₁,R₂ und/oder R₃ mit weiteren Substituenten am Phenylring oder mit einem der Kohlenstoffatome am Phenylring bilden;
R' eine lineare oder verzweigte C₁-C₆ Alkylgruppe oder ein C₅-C₈ Zykloalkyl ist, und R" ein (C=O)R"' ist.

3. Photopolymerisierbare Systeme gemäß Patentanspruch 2, worin R ein Phenyl oder Naphthyl und R' ein Methyl ist.

4. Verbindung aus Formel (I), worin X und Y ein S sind, R ein Naphthyl, R' ein Methyl und R" ein (C=O)R'" mit Isopropyl für R"' ist.

5. Verbindung aus Formel (I), worin X und Y ein S, R ein Naphthyl, R' ein Methyl und R" ein (C=O)R'" mit Zyklohexyl für R'" ist.

6. Photopolymerisierbare Systeme gemäß Patentanspruch 1, die als Photoinitiator mindestens eine Verbindung aus Formel (I) enthalten, worin X, Y, R, R' und R" irgendeine der in Patentanspruch 1 aufgeführten Bedeutungen hat, unter der Bedingung, dass sich R von (i) unterscheidet.

7. Photopolymerisierbare Systeme gemäß Patentanspruch 6, worin der Sensitizer ausgewählt wird aus: Thioxanthon, 2-Isopropylthioxanthon, Mischung aus 2-,4-Isopropylthioxanthon, 2-Chlorothioxanthon, 2-Dodecylthioxanthon, 2,4-Diethylthioxanthon, 2,4-Dimethylthioxanthon, 1-Chloro-4-propoxythioxanthon, 1-Methoxycarbonylthioxanthon, 2-Ethoxycarbonylthioxanthon, 3-(2-Methoxyethoxycarbonyl)-thioxanthon, 4-Butoxycarbonylthioxanthon, 3-Butoxycarbonyl-7-methylthioxanthon, 1-Cyano-3-chlorothioxanthon, 1-Ethoxycarbonyl-3-chlorothioxanthon, 1-Ethoxycarbonyl-3-ethoxythioxanthon, 1-Ethoxycarbonyl-3-amino-thioxanthon, 1-Ethoxycarbonyl-3-phenylsulfurylthioxanthon, 3,4,-di-[2-(2-Methoxyethoxy ethoxycarbonyl]-thioxanthon, 1-Ethoxycarbonyl-3-(1-methyl-1-morpholinoethyl)-thioxanthon, 2-Methyl-6-dimethoxymethyl-thioxanthon und eine Mischung aus diesen.

8. Photopolymerisierbare Systeme gemäß Patentanspruch 6, worin der Sensitizer ausgewählt wird aus: Thioxanthon, 2-Isopropylthioxanthon, Mischung aus 2-,4-Isopropylthioxanthon, 2-Chlorothioxanthon, 2,4-Dimethylthioxanthon und 1-Chloro-4-propoxythioxanthon.

9. Prozess zur Herstellung von Beschichtungen für Metall, Holz, Papier oder Kunststoffoberflächen, bestehend aus: a) Anwendung des photopolymerisierbaren Systems einschließlich der reaktiven Oligomere und/oder Monomere, die ethylenisch ungesättigte Gruppen und mindestens eine Verbindung der Formel (I) besitzen 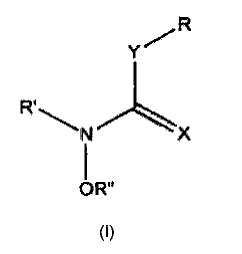 worin X, Y, R, R' und R" irgendeine der in Patentanspruch 1 aufgeführten Bedeutungen hat
b) Photopolymerisation mit einer Lichtquelle, die eine Emissionsbande im sichtbaren UV-Bereich bis zu 450 nm hat, um nach der Polymerisation eine Beschichtung von einer Stärke zwischen 0.1 und 100 Mikron zu erhalten.

10. Prozess zur Herstellung von photolithografischen Abbildungen, vorzugsweise auf Metalloberflächen, bestehend aus: a) Anwendung des photopolymerisierbaren Systems einschließlich reaktiver Oligomere und/oder Monomere, die ethylenisch ungesättigte Gruppen, ein nicht-reaktives Polymer und ein nicht-reaktives Polyacrylat und mindestens eine Verbindung der Formel I besitzen 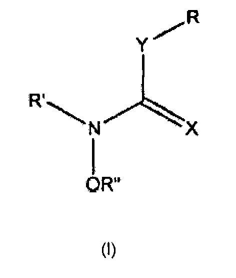 worin X, Y, R, R' und R" irgendeine der in Patentanspruch 1 aufgeführte Bedeutung hat; b) Photopolymerisation durch einen Negativfilm mit einer Lichtquelle, die Emissionsbanden im sichtbaren UV-Bereich bis zu 450 nm hat oder durch ein Laserlicht, das eine geeignete Wellenlänge (z.B. 405 nm) und eine Leistung aufweist, die es ermöglicht, nach entsprechender Entwicklung ein Bild mit einer Stärke von 0.1 bis 3 Mikron zu erhalten.

## Revendications

1. Systèmes photopolymérisables comprenant des oligomères et/ou des monomères polymérisables par photopolymérisation radicalaire comprenant des groupes à insaturation éthylénique et, comme photo-initiateur, au moins un composé de formule (I) : 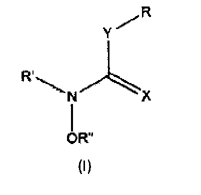 dans laquelle
X et Y sont, indépendamment l'un de l'autre, O ou 5 ;
R est un phényle ou un phényle substitué par un ou plusieurs radicaux alkyle linéaire ou ramifié en C₁ à C₁₂ ou cycloalkyle en C₅ à C₈, alkyle halogéné en C₁ à C₄, atome d'halogène, groupe nitro, groupe cyano, phényle, benzoyle, OR₀, NR₁R₂, SR₃, benzoyle, S(=O)-phényle, S(=O)₂-phényle et/ou -S-phényle, les substituants OR₀, NR₁R₂, SR₃ formant éventuellement des anneaux à 5 ou 6 membres via les radicaux R₀, R₁, R₂ et/ou R₃, avec d'autres substituants du noyau phényle ou avec l'un des atomes de carbone du noyau phényle,
ou bien R est 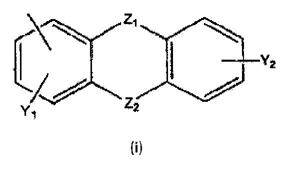 où Z₁ et Z₂ sont indépendamment l'un de l'autre une liaison simple, S, O, S=O, S(=O)₂, C=O, C=S, NR₁, C(=N)R₁, un alkylène en C₁ à C₂ éventuellement substitué par un alkyle en C₁ à C₁₂, et Y₁ et Y₂ sont, indépendamment l'un de l'autre, un alkyle linéaire ou ramifié en C₁ à C₁₂, un alkyle halogéné en C₁ à C₄, un cycloalkyle, un atome d'halogène, un phényle, un benzyle, OR₀, NR₁R₂, SR₃, un benzoyle, un 5(=O)-phényle, un S(=O)₂-phényle et/ou un -S-phényle, les substituants OR₀, NR₁R₂, SR₃ formant éventuellement des anneaux à 5 ou 6 membres via les radicaux R₀, R₁, R₂ et/ou R₃, avec d'autres substituants du noyau aromatique phényle ou avec l'un des atomes de carbone du noyau aromatique,
ou bien R est un naphtyle, un anthracyle, un phénanthryle, les radicaux naphtyle, anthracyle et phénanthryle étant éventuellement substitués par un ou plusieurs radicaux alkyle linéaire ou ramifié en C₁ à C₆ ou cycloakyle en C₅ à C₈, phényle, OR₀, NR₁R₂, SR₃ et/ou un -S-phényle, les substituants OR₀, NR₁R₂, SR₃ formant éventuellement des anneaux à 5 ou 6 membres via les radicaux R₀, R₁, R₂ et/ou R₃, avec d'autres substituants du noyau naphtyle, anthracyle ou phénanthryle ou avec l'un des atomes de carbone du noyau naphtyle, anthracyle ou phénanthryle, ou bien R est un radical insaturé hétérocyclique à 5 ou 6 membres comprenant un ou plusieurs hétéroatomes choisis parmi O, S et N, ledit radical étant éventuellement substitué par un alkyle en C₁ à C₆, un phényle, OR₀, NR₁R₂, SR₃ et/ou un -S-phényle, les substituants OR₀, NR₁R₂, SR₃ formant éventuellement des anneaux à 5 ou 6 membres via les radicaux R₀, R₁, R₂ et/ou R₃, avec d'autres substituants du radical insaturé hétérocyclique, ou avec l'un des atomes de carbone du radical insaturé hétérocyclique;
R' est un groupe alkyle linéaire ou ramifié en C₁ à C₁₂ ou un cycloalkyle en C₅ à C₈, éventuellement substitué par OH, un alcoxy en C₁ à C₄, SH, NR₁R₂, un phényle, un benzyle, un benzoyle, un alkylsulfonyle en C₁ à C₁₂, un phénylsulfonyle, un (4-méthylphényl)sulfonyle et/ou un alcanoyle en C₁ à C₆, ou un cycloalkyle en C₅ à C₈,
ou bien R' est un alkyle en C₂ à C₁₂ coupé par un ou plusieurs -O-, ledit alkyle en C_{z} à C₁₂ coupé étant éventuellement substitué par OH, un alcoxy en C₁ à C₄, un alkylsulfonyle en C₁ à C₁₂, un phénylsulfonyle, un (4-méthylphényl)sulfonyle et/ou un alcanoyle en C₁ à C₆,
ou bien R' est un phényle, ou un phényle substitué par un ou plusieurs radicaux alkyle en C₁ à C₁₂ ou cycloalkyle en C₅ à C₈, un alkyle halogéné en C₁ à C₄, un atome d'halogène, un phényle, OR₀, NR₁R₂, SR₃, un benzoyle, un S(=O)-phényle, un S(=O)₂-phényle et/ou un -S-phényle, les substituants OR₀, NR₁R₂, SR₃ formant éventuellement des anneaux à 5 ou 6 membres via les radicaux R₀, R₁, R₂ et/ou R₃, avec d'autres substituants du noyau phényle, ou avec l'un des atomes de carbone du noyau phényle ;
R" répond à l'une des définitions de R',
ou bien R" est (C=O)R"', où R"' répond à l'une des définitions de R' ;
R₀ est un atome d'hydrogène, un phényle, un benzyle, un alkyle en C₁ à C₁₂ ou un cycloalkyle en C₅ à C₈, lesquels sont éventuellement substitués par un phényle, un benzyle, un benzoyle, OH, un alcoxy en C₁ à C₁₂, un alkylsulfonyle en C₁ à C₁₂, un phénylsulfonyle, un (4-méthylphényl)sulfonyle et/ou un alcanoyle en C₂ à C₆,
ou bien R₀ est un alkyle en C₂ à C₁₂ coupé par un ou plusieurs -O-, ledit alkyle en C₂ à C₁₂ coupé étant éventuellement substitué par un phényle, OH, un alcoxy en C₁ à C₄, un alkylsulfonyle en C₁ à C₁₂, un phénylsulfonyle, un (4-méthylphényl)sulfonyle et/ou un alcanoyle en C₂ à C₆ ;
R₁ et R₂ sont, indépendamment l'un de l'autre, un atome d'hydrogène, un alkyle en C₁ à C₁₂ éventuellement substitué par un groupe OH, un alcoxy en C₁ à C₄, un alkylsulfonyle en C₁ à C₁₂, un phénylsulfonyle, un (4-méthylphényl)sulfonyle et/ou un alcanoyle en C₁ à C₆,
ou bien R₁ et R₂ sont un alkyle en C₂ à C₁₂ ou un cycloalkyle coupé par un ou plusieurs -O-, ledit alkyle en C₂ à C₁₂ coupé étant éventuellement substitué par un groupe OH, un alcoxy en C₁ à C₄, un alkylsulfonyle en C₁ à C₁₂, un phénylsulfonyle, un (4-méthylphényl)sulfonyle et/ou un alcanoyle en C₁ à C₆,
ou bien R₁ et R₂ sont un phényle, un alcanoyle en C₂ à C₆, un benzoyle, un alkylsulfonyle en C₁ à C₆, un phénylsulfonyle, un (4-méthylphényl)sulfonyle, un naphtylsulfonyle, un anthracylsulfonyle ou un phénanthrylsulfonyle,
ou bien R₁ et R₂ forment, avec l'atome d'azote auquel ils sont liés, un cycle à 5, 6 ou 7 membres éventuellement coupé par-O-, -5- ou -NR₀- ;
R₃ est un alkyle en C₁ à C₁₂ ou un cycloalkyle en C₅ à C₈ éventuellement substitué par un groupe OH et/ou un alcoxy en C₁ à C₄,
ou bien R₃ est un alkyle en C₂ à C₁₂ coupé par un ou plusieurs -O-, ledit alkyle en C₂ à C₁₂ coupé étant éventuellement substitué par un groupe OH et/ou un alcoxy en C₁ à C₄.

2. Systèmes photopolymérisables selon la revendication 1, R étant un naphtyle, le radical naphtyle étant éventuellement substitué par un ou plusieurs radicaux alkyle linéaire ou ramifié en C₁ à C₆ ou cycloalkyle en C₅ à C₈, phényle, OR₀, NR₁R₂, SR₃ et/ou -S-phényle, les substituants OR₀, NR₁R₂, SR₃ formant éventuellement des anneaux à 5 ou 6 membres via les radicaux R₀, R₁, R₂ et/ou R₃, avec d'autres substituants du noyau naphtyle ou avec l'un des atomes de carbone du noyau naphtyle,
ou bien R est un phényle ou un phényle substitué par un plusieurs radicaux alkyle linéaire ou ramifié en C₁ à C₁₂ ou cycloalkyle en C₅ à C₈, alkyle halogéné en C₁ à C₄, atome d'halogène, groupe nitro, groupe cyano, phényle, benzyle, OR₀, NR₁R₂, SR₃, benzoyle, S(=O)-phényle, S(=O)₂-phényle et/ou -5-phényle, les substituants OR₀, NR₁R₂, SR₃ formant éventuellement des anneaux à 5 ou 6 membres via les radicaux R₀, R₁, R₂ et/ou R₃, avec d'autres substituants du noyau phényle ou avec l'un des atomes de carbone du noyau phényle ;
R' est un alkyle linéaire ou ramifié en C₁ à C₆ ou un cycloalkyle en C₅ à C₈,
et R" est (C=O)R"'.

3. Systèmes photopolymérisables selon la revendication 2, R étant un phényle ou un naphtyle et R' étant un méthyle.

4. Composé de formule (I) où X et Y sont un atome de soufre, R est un naphtyle, R' est un méthyle et R" est (C=O)R"', R"' étant un isopropyle.

5. Composé de formule (I) où X et Y sont un atome de soufre, R est un naphtyle, R' est un méthyle et R" est (C=O)R"', R"' étant un cyclohexyle.

6. Systèmes photopolymérisables selon la revendication 1 comprenant, en tant que photo-initiateur, au moins un composé de formule I où X, Y, R, R' et R" répondent à l'une quelconque des définitions détaillées dans la revendication 1, à condition que R soit différent de (i).

7. Système photopolymérisable selon la revendication 6, dans lequel le sensibilisateur est choisi parmi les composé suivants: thioxanthone, 2-isopropylthioxanthone, mélange de 2-et de 4-isopropylthioxanthone, 2-chlorothioxanthone, 2-dodécylthioxanthone, 2,4-diéthylthioxanthone, 2,4-diméthylthloxanthone, 1-chloro-4-propoxythioxanthone, 1-méthoxycarbonylthioxanthone, 2-éthoxycarhonylthioxanthone,3-(2-méthoxyéthoxycarbonyl)thioxanthone, 4-butoxycarbonylthioxanthone,3-butoxycarbonyl-7-méthylthioxanthone, 1-cyano-3-chlorothioxanthone, 1-éthoxycarbonyl-3-chlorothioxanthone, 1-éthoxycarbonyl-3-éthoxythioxanthone, 1-éthoxycarbonyl-3-aminothioxanthone, 1-éthoxycarbonyl-3-phénylsulfurylthioxanthone, 3,4-di-[2-(2-méthoxyéthoxyéthoxycarbonyl)]thioxanthone, 1-éthoxycarhonyl-3-(1-méthyl-1-morpholinoéthyl)thioxanthone, 2-méthyl-6-diméthoxyméthylthioxanthone, et leurs mélanges.

8. Système photopolymérisable selon la revendication 6, dans lequel le sensibilisateur est choisi parmi les composés suivants: thioxanthone, 2-isopropylthioxanthone, mélange de 2- et de 4-isopropylthioxanthone, 2-chlorothioxanthone, 2,4-diméthylthioxanthone et 1-chloro-4-propoxythioxanthone.

9. Procédé de réalisation de revêtements pour surfaces en métal, bois, papier ou plastique, comprenant a) l'application du système photopolymérisable comprenant des oligomères et/ou monomères réactifs comprenant des groupes à insaturation éthylénique et au moins un composé de formule I 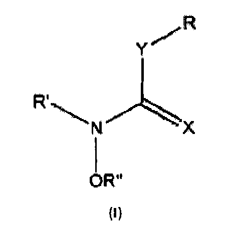 dans laquelle X, Y, R, R' et R" répondent à l'une quelconque des définitions détaillées dans la revendication 1,
b) la photopolymérisation avec une source lumineuse comprenant des bandes d'émission dans la région UV-visible jusqu'à 450 nm afin d'obtenir, après polymérisation, un revêtement d'épaisseur 0,1 à 100 microns.

10. Procédé de réalisation d'images photolithographiques, de préférence sur des surfaces métalliques, ledit procédé comprenant : a) l'application du système photopolymérisable comprenant des oligomères et/ou monomères réactifs comprenant des groupes à insaturation éthylénique, un polymère non réactif tel qu'un polyacrylate non réactif et au moins un composé de formule I 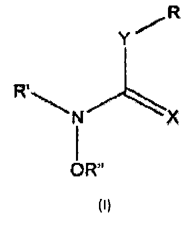 dans laquelle X, Y, R, R' et R" répondent à l'une quelconque des définitions détaillées dans la revendication 1; b) la photopolymérisation à travers une pellicule négative avec une source lumineuse comprenant des bandes d'émission dans la région UV-visible jusqu'à 450 nm ou avec une lumière laser de longueur d'onde appropriée (c'est-à-dire 405 nm) et de puissance appropriée afin d'obtenir, après un développement adapté, une image d'épaisseur 0,1 à 3 microns.
